# EUROPEAN PATENT APPLICATION

(11) **EP 2 869 677 A1**
(43) Date of publication of application: **06.05.2015**
(21) Application number: 13808900.8
(22) Date of filing: 28.02.2013
(51) Int. Cl.: H05K 3/38, H05K 1/09, H05K 3/24

(54) **CIRCUIT BOARD, METHOD FOR FORMING CONDUCTIVE FILM, AND ADHESION IMPROVER**

(30) Priority: 27.06.2012 JP 2012144747
(71) Applicant: Ishihara Chemical Co., Ltd., Kobe-shi Hyogo 652-0806 (JP)
(72) Inventor: KAWATO, Yuichi, Kobe-shi Hyogo 652-0806 (JP); MITA, Tomohiro, Kobe-shi Hyogo 652-0806 (JP); MAEDA, Yusuke, Kobe-shi Hyogo 625-0806 (JP); KUDO, Tomio, Kobe-shi Hyogo 652-0806 (JP)
(74) Representative: Hoefer & Partner
(86) International application number: PCT/JP2013/055415
(87) International publication number: WO 2014/002529

(57) **Abstract**

In a conductive film formed by photo sintering of a film composed of copper particulates, adhesiveness to a base material of the conductive film is improved.

A circuit board 1 includes a circuit including a conductive film 2, and a substrate 3. The circuit board 1 further includes a resin layer 4 between the substrate 3 and the conductive film 2. The substrate 3 is made of a non-thermoplastic base material 31. The resin layer 4 contains a thermoplastic resin. The conductive film 2 is formed by photo sintering of a film composed of copper particulates 21, and thus improving adhesiveness of the conductive film 2 to the base material 31 through the resin layer 4.

## Description

### TECHNICAL FIELD

The present invention relates to a circuit board including a conductive film formed by photo sintering of a film composed of copper particulates, a conductive film forming method in which the conductive film is formed on a base material, and an adhesiveness improver which improves adhesiveness to the base material of the conductive film.

### BACKGROUND ART

There has hitherto existed a circuit board (printed circuit board) in which a circuit composed of a copper foil is formed on a substrate by photolithography. Photolithography includes the step of etching a copper foil and high costs are required for a treatment of waste fluid generated by etching and the like.

There has been known, as the technology requiring no etching, a method in which a conductive film is formed on a substrate using a copper particulate dispersion (copper ink) containing copper particulates (copper nanoparticles) dispersed in a dispersion vehicle (see, for example, Patent Document 1). According to this method, a liquid film of a copper particulate dispersion is formed on a substrate, and the liquid film is dried to form a film composed of copper particulates. This film undergoes bulking due to photo sintering, and thus a conductive film is formed. The substrate is made of a non-thermoplastic base material such as glass or polyimide so that the material can endure heat generation of copper particulates caused by absorbing energy of light.

This conductive film has low electric resistance, and has adhesiveness to a base material to such a degree that the film is not peeled by an adhesive tape. However, when an attempt is made to increase the thickness of a conductive film so as to further lower electric resistance, the conductive film may be likely to be peeled.

### PRIOR ART DOCUMENT

Patent Document 1: U.S. Patent Application Serial No. 2008/0286488

### SUMMARY OF THE INVENTION

### PROBLEMS TO BE SOLVED BY THE INVENTION

The present invention is made so as to solve the above-mentioned problems and an object thereof is to improve adhesiveness of a conductive film, which is formed by photo sintering of a film composed of copper particulates, to a base material of the conductive film.

### MEANS FOR SOLVING THE PROBLEMS

A circuit board of the present invention includes a circuit including a conductive film, and a substrate, and is characterized by further including: a resin layer between the substrate and the conductive film, the substrate being made of a non-thermoplastic base material, the resin layer containing a thermoplastic resin, and the conductive film being formed by photo sintering of a film composed of copper particulates.

In this circuit board, the thermoplastic resin is preferably selected from the group consisting of a thermoplastic polyimide resin, a polyamideimide resin, a polyphenylene sulfide resin, a polyurethane resin, a polyvinyl chloride resin and a styrol resin.

In this circuit board, plating is preferably applied to the conductive film.

In this circuit board, the plating is preferably electroplating or electroless plating.

An adhesiveness improver of the present invention is used in the formation of the resin layer in the above circuit board, and is characterized by being produced by dissolving the thermoplastic resin in a solvent.

A conductive film forming method of the present invention is a method in which a conductive film is formed on a base material, and is characterized by including the steps of: forming a resin layer on a non-thermoplastic base material using an adhesiveness improver containing a thermoplastic resin, forming a film composed of copper particulate on the resin layer using a copper particulate dispersion, and subjecting the film to photo sintering.

In this conductive film forming method, the thermoplastic resin is preferably selected from the group consisting of a thermoplastic polyimide resin, a polyamideimide resin, a polyphenylene sulfide resin, a polyurethane resin, a polyvinyl chloride resin and a styrol resin.

In this conductive film forming method, it is preferred to further include the step of applying plating to the photo-sintered film.

In this conductive film forming method, the plating is preferably electroplating or electroless plating.

An adhesiveness improver of the present invention is the adhesiveness improver used in the above conductive film forming method, and may be produced by dissolving the thermoplastic resin in a solvent.

### ADVANTAGES OF THE INVENTION

According to the circuit board of the present invention, it includes a resin layer containing a thermoplastic resin, and thus improving adhesiveness of the conductive film to the base material through the resin layer.

### BRIEF DESCRIPTION OF THE DRAWINGS

[Fig. 1] Fig. 1 is a cross-sectional schematic view of a circuit board according to an embodiment of the present invention.
[Fig. 2] Figs. 2(a) to 2(f) are cross-sectional schematic views showing a conductive film forming method in forming the circuit board in chronological order.

### BEST MODE FOR CARRYING OUT THE INVENTION

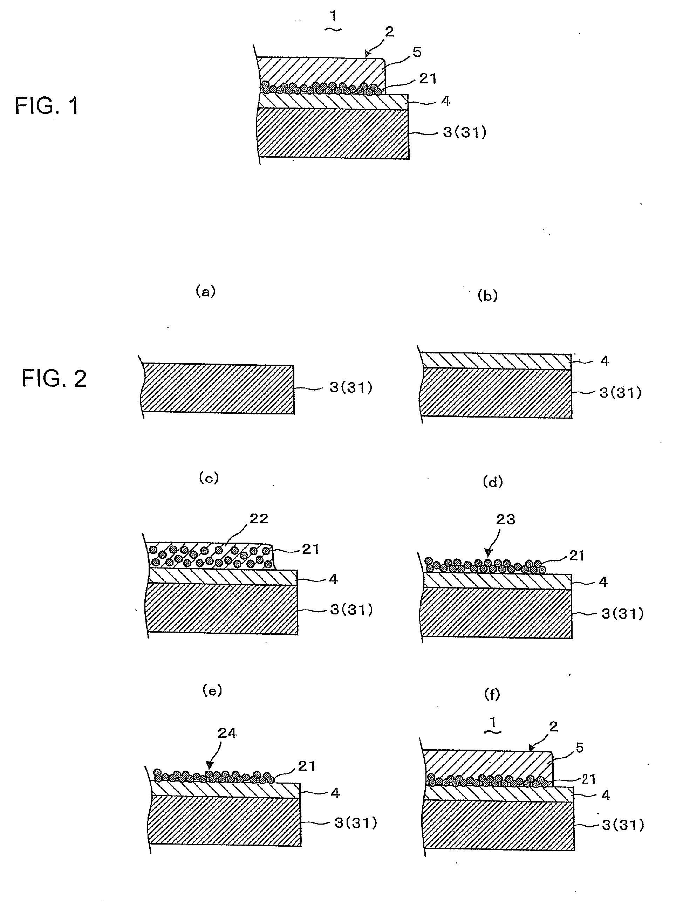

A circuit board according to an embodiment of the present invention will be described with reference to Fig. 1. A circuit board 1 includes a circuit including a conductive film 2, and a substrate 3. This circuit board 1 further includes a resin layer 4 between the substrate 3 and the conductive film 2. The substrate 3 is made of a non-thermoplastic base material 31. The resin layer 4 contains a thermoplastic resin. The conductive film 2 is formed by photo sintering of a film composed of copper particulates 21. In the present embodiment, plating 5 is applied to the conductive film 2. Plating 5 is electroplating. Plating 5 may also be electroless plating. Plating 5 may be omitted in a part or all of the conductive film 2.

In the formation of the resin layer 4, an adhesiveness improver is used. The adhesiveness improver is produced by dissolving the thermoplastic resin in a solvent.

A circuit board 1 will be described in more detail. The circuit board 1 is a printed circuit board. The circuit includes a conductive film 2. The conductive film 2 constitutes, for example, a conducting wire which creates an electrical connection between circuit elements. The conductive film 2 may constitute circuit elements or a portion thereof, for example, electrodes of a capacitor or a coil and the like. Copper particulates 21 used for the formation of the conductive film 2 are nanoparticles having a median particle diameter of 1 nm or more and less than 100 nm. The substrate 3 is obtained by forming a base material 31 into a plate shape. The base material 31 is a material having non-thermoplasticity and high heat resistance, and examples thereof include, but are not limited to, glass, a non-thermoplastic polyimide, ceramics, a thermosetting resin, a silicon wafer and the like. The resin layer 4 is a layer which is formed on the base material 31 as a primer coating of the conductive film 2. Examples of the thermoplastic resin contained in the resin layer 4 include, but are not limited to, a thermoplastic polyimide resin, a polyamideimide resin, a polyphenylene sulfide resin, a polyurethane resin, a polyvinyl chloride resin, a styrol resin and the like. The resin layer 4 is not limited to a single layer, and a plurality of layers made of different kinds of resins may be laminated.

Plating 5 is applied so as to increase the thickness of the conductive film 2. When plating 5 is electroplating, examples of the plating metal include, but are not limited to, copper, nickel, tin, chromium, palladium, gold, bismuth, cobalt, iron, silver, lead, platinum, iridium, zinc, indium, ruthenium, rhodium and the like. When plating 5 is electroless plating, examples of the plating metal include, but are not limited to, copper, tin, silver, nickel, palladium, gold and the like. Plating may also be alloy plating.

A conductive film forming method in the formation of a circuit board 1 configured as mentioned above will be described with reference to Figs. 2(a) to 2(f). As shown in Fig. 2(a) and 2(b), on a substrate 3 made of a base material 31, an adhesiveness improver is applied in a predetermined thickness, and then a solvent of the adhesiveness improver is dried to form a resin layer 4.

As shown in Fig. 2(c), a liquid film 22 made of a copper particulate dispersion is formed on the resin layer 4. The copper particulate dispersion is a liquid containing copper particulates 21 dispersed therein. The liquid film 22 on the resin layer 4 is formed, for example, by a printing method. In the printing method, the copper particulate dispersion is used as an ink for printing, and a predetermined pattern is printed on the resin layer 4 by a printing device to form a liquid film 22 with the pattern. Next, the liquid film 22 is dried. As shown in Fig. 2(d), copper particulates 21 remain on the resin layer 4 by drying of the liquid film 22, and thus a film 23 composed of copper particulates 21 is formed on the resin layer 4.

Next, the film 23 composed of copper particulates 21 is irradiated with light and this film 23 is subjected to photo sintering. In photo sintering, a surface-oxidized film of copper particulates 21 in the film 23 is removed, and also copper particulates 21 are sintered. As shown in Fig. 2(e), copper particulates 21 are mutually melted and welded to the resin layer 4 in sintering. Photo sintering is performed at room temperature under atmospheric air. A light source used in photo sintering is, for example, a xenon lamp. A laser device may be used as the light source. The photo-sintered film 24 undergoes bulking by irradiation with light and imparted with conductivity, and also adheres to the resin layer 4.

Next, plating 5 is applied to the photo-sintered film 24. This plating 5 is electroplating or electroless plating. In the electroplating, the photo-sintered film 24 is immersed in a plating solution and serves as a cathode which is a seed layer. In the electroless plating, the photo-sintered film 24 serves as a catalytically active seed layer to an oxidation reaction of a reducing agent contained in the plating solution. As shown in Fig. 2(f), plating 5 enables an increase in thickness (increase in plating thickness) of the conductive film 2.

In this conductive film forming method, energy of light, with which the film 23 composed of copper particulates 21 is irradiated, is set so as not to cause damage of the resin layer 4 containing a thermoplastic resin, thus leading to insufficient bulking of the photo-sintered film 24, resulting in high electric resistance (sheet resistance). Since this film 24 has high electric resistance but has conductivity, it can be used as a seed layer in electroplating. In the electroless plating, the electric resistance of the seed layer should never be a problem. Accordingly, it is possible to apply plating to the photo-sintered film 24. Electric resistance of the conductive film 2 corresponds to a resistance value of bulk metal by plating 5.

Unlike the present embodiment, when a film composed of copper particulates 21 is directly formed on a non-thermoplastic base material 31 such as glass without forming a resin layer 4, the film formed by photo sintering has satisfactory adhesiveness to the base material 31 to such a degree that the film is not peeled by an adhesive tape, and has low electric resistance (sheet resistance). This is because welding to the base material 31 and bulking of the film are sufficiently performed since it is possible to increase irradiation energy of light in photo sintering. It is necessary to increase the thickness so as to further lower electric resistance of this film. However, the inventors of the present invention have found by the test that, when plating is applied to the film to form a conductive film 2 for increasing the thickness, it becomes easy to peel the plated conductive film 2 from the base material 31.

It is considered that such peeling of the conductive film 2 by plating is due to the following action. If irradiation energy of light in photo sintering is sufficiently large, the film formed by photo sintering of the film composed of copper particulates 21 has satisfactory adhesiveness to the base material 31 to such a degree that the film is not peeled by an adhesive tape. However, because of non-thermoplasticity of the base material 31, copper particulates 21 are not sufficiently welded to the base material 31. Therefore, it becomes easy for the conductive film 2 formed by applying plating to the film to peel from the base material 31 due to internal stress which remains inside the plated layer of the conductive film 2. The above-mentioned action is one theory for explaining the test results and does not limit the present invention.

The inventors of the present invention have found by the test that, like the present embodiment, when a resin layer 4 containing a thermoplastic resin is formed on the base material 31 and plating 5 is applied to a film 24 formed on the resin layer 4 by photo sintering, it becomes difficult for the formed conductive film 2 to peel.

It is considered that such improvement in adhesiveness to the conductive film 2 of the resin layer 4 is due to the following action. When the film 23 composed of copper particulates 21 is subjected to photo sintering, the copper particulates 21 absorb energy of light to generate heat, while the copper particulates 21 adjacent to the resin layer 4 are strongly welded so as to bite into the resin layer 4. Because of insufficient bulking of the photo-sintered film 24 by photo sintering, even if space is formed between copper particulates 21, the space is filled with metal which is precipitated in plating, and thus the film undergoes bulking. The conductive film 2 formed by such bulking is prevented from peeling from the resin layer 4 since the copper particulates 21 welded strongly to the resin layer 4 serves as an anchor. The above-mentioned action is one theory for explaining the test results and does not limit the present invention.

As is apparent from the test of the inventors of the present invention, even if a layer containing no thermoplastic resin is formed on the base material 31, adhesiveness of the conductive film 2 is not improved by the layer.

A copper particulate dispersion used in this conductive film forming method will be described in detail. The copper particulate dispersion includes copper particulates 21, at least one kind of a dispersion vehicle containing the copper particulates 21, and at least one kind of a dispersant. The dispersion vehicle is, for example, a protic dispersion vehicle, or an aprotic polar dispersion vehicle having a dielectric constant of 30 or more. The dispersant allows copper particulates 21 to disperse in a dispersion vehicle and is, for example, a compound having at least one acidic functional group and a molecular weight of 200 or more and 100,000 or less, or a salt thereof.

Examples of the protonic dispersion vehicle include, but are not limited to, 3-methoxy-3-methylbutanol, triethylene glycol monomethyl ether, diethylene glycol monobutyl ether, diethylene glycol monomethyl ether, propylene glycol monobutyl ether, ethylene glycol monohexyl ether, ethylene glycol mono-tert-butyl ether, 2-octanol, 2-methylpentane-2,4-diol, ethylene glycol, propylene glycol, 1,5-pentanediol, diethylene glycol, triethylene glycol, glycerol, sorbitol and the like.

Examples of the aprotic polar dispersion vehicle having a dielectric constant of 30 or more include, but are not limited to, propylene carbonate, 1,3-dimethyl-2-imidazolidinone, hexamethylphosphoramide, N-methylpyrrolidone, N-ethylpyrrolidone, nitrobenzene, N, N-diethylformamide, N, N-dimethylacetamide, furfural, γ-butyrolactone, ethylene sulfite, sulfolane, dimethyl sulfoxide, succinonitrile, ethylene carbonate and the like.

The dispersant has, for example, a phosphoric acid group, a phosphonic acid group, a sulfonic acid group, a sulfuric acid group or a carboxyl group as an acidic functional group.

As mentioned above, since a circuit board 1 of the present embodiment includes a resin layer 4 containing a thermoplastic resin, a conductive film 2 is welded to the resin layer 4 in photo sintering, and thus improving adhesiveness to a base material 31 through the resin layer 4.

Improvement in adhesiveness prevents the conductive film 2 from peeling even if plating 5 is applied thereto. Application of plating 5 to the conductive film 2 enables the conductive film 2 to undergo bulking and an increase in film thickness, and thus lowering electric resistance of the conductive film 2, leading to an increase in ampacity.

According to a conductive film forming method of the present embodiment, since an adhesiveness improver produced by dissolving the thermoplastic resin in a solvent is used, a resin layer 4 can be easily formed. Since a copper particulate dispersion is used, a film 23 composed of copper particulates 21 can be easily formed by a printing method and the like, and thus a conductive film 2 can be easily formed by photo sintering of the film 23.

Using a conductive film forming method of the present invention, a conductive film 2 was formed on a base material 31 as Example, and the thus formed conductive film 2 was tested and evaluated.

### [Example 1]

A polyimide film having heat resistance (manufactured by Du Pont-Toray Co., Ltd. under the trade name of "Kapton (registered trademark) 200EN") was used as a base material 31. A polyimide ink containing a polyimide resin (thermoplastic resin), which contains a block-copolymerized polyimide as a main component, was used as an adhesiveness improver. This adhesiveness improver was applied on a base material 31 by a spin coating method and then dried under atmospheric air at 100°C to 250°C for 30 minutes so as to dry a solvent to form a 0.5 µm thick resin layer 4. On this resin layer 4, a copper particulate dispersion (manufactured by ISHIHARA CHEMICAL CO., LTD. under the trade name of "CJ-0104") was applied by a spin coating method and then dried under atmospheric air at 100°C for 30 minutes, followed by photo sintering using a flash irradiation device with a xenon lamp to produce a sample substrate. Photo sintering was performed at irradiation energy within a range of 0.5 J/cm² or more and 30 J/cm² or less for 0.1 ms to 10 ms per time, and irradiation was performed once or several times until a conductive film having sheet resistance of about 1,000 mΩ/□ or less is obtained.

Next, initial make-up of electrolytic bath of an electrolytic copper plating solution was performed. Electrolytic copper plating is electroplating in which plated metal is copper. The composition of this plating solution was as follows: 120 g/L of copper sulfate pentahydrate as a supply source of divalent copper ions, 180 g/L of sulfuric acid, 25 ppm of hydrochloric acid, and pure water (balance).

The sample substrate was subjected to a pretreatment in 10 wt% sulfuric acid and then immediately washed with pure water. The sample substrate was then immersed in the above electrolytic copper plating solution, and electrolytic copper plating was applied to the sample substrate under the conditions of a liquid temperature of 25°C and a cathode current density of 4.0 A/dm². The sample substrate was washed with pure water and dried. The plating thickness of the conductive film 2 in the sample substrate was 10 µm.

Adhesiveness of a conductive film 2 was tested by a cross-cut tape method (JIS K5600). In this test, 25 squares in a grid pattern were formed on a test surface of the conductive film 2 by making cuts in the surface and an adhesive tape was applied to the cut squares and the pressure-sensitive adhesive tape was peeled, and then the test surface was observed. The number of squares, which remained without being peeled, was 25 among 25 squares.

### [Example 2]

In the same manner as in Example 1, except that the thickness of the resin layer 4 was set to 1 µm, a test substrate was produced. Adhesiveness of a conductive film 2 was tested by the cross-cut tape method. The number of squares, which remained without being peeled, was 25 among 25 squares.

### [Example 3]

In the same manner as in Example 2, except that the thickness of the resin layer 4 was set to 2 µm, a test substrate was produced. Adhesiveness of the conductive film 2 was tested by the cross-cut tape method. The number of squares, which remained without being peeled, was 25 among 25 squares.

### [Example 4]

In the same manner as in Example 3, except that a resin solution containing a polyamideimide resin (thermoplastic resin) was used as the adhesiveness improver, the thickness of the resin layer 4 was set to 0.3 µm, and the plating thickness of the conductive film 2 was set to 5 µm, a test substrate was produced. Adhesiveness of the conductive film 2 was tested by the cross-cut tape method. The number of squares, which remained without being peeled, was 25 among 25 squares.

### [Example 5]

In the same manner as in Example 4, except that another resin solution containing a polyimide varnish (thermoplastic resin) was used as the adhesiveness improver, a test substrate was produced. Adhesiveness of the conductive film 2 was tested by the cross-cut tape method. The number of squares, which remained without being peeled, was 25 among 25 squares.

### [Example 6]

In the same manner as in Example 5, except that another resin solution containing a polyester (thermoplastic resin) was used as the adhesiveness improver and the thickness of the resin layer 4 was set to 1 µm, a test substrate was produced. Adhesiveness of the conductive film 2 was tested by the cross-cut tape method. The number of squares, which remained without being peeled, was 25 among 25 squares.

### [Example 7]

In the same manner as in Example 6, except that a non-alkali glass (manufactured by Corning Incorporated under the trade name of "EAGLE XG") was used as the base material 31, a test substrate was produced. Adhesiveness of the conductive film 2 was tested by the cross-cut tape method. The number of squares, which remained without being peeled, was 25 among 25 squares.

### [Example 8]

In the same manner as in Example 7, except that a resin solution containing a polyphenylene sulfide resin (thermoplastic resin) was used as the adhesiveness improver and the thickness of the resin layer 4 was set to 0.3 µm, a test substrate was produced. Adhesiveness of the conductive film 2 was tested by the cross-cut tape method. The number of squares, which remained without being peeled, was 23 among 25 squares.

### [Example 9]

In the same manner as in Example 8, except that a soda glass was used as the base material 31, a resin solution containing a polyurethane resin (thermoplastic resin), which contains a polyurethane/silica hybrid resin as a main component, was used as the adhesiveness improver, and the thickness of the resin layer 4 was set to 1 µm, a test substrate was produced. Adhesiveness of the conductive film 2 was tested by the cross-cut tape method. The number of squares, which remained without being peeled, was 5 among 25 squares.

### [Example 10]

In the same manner as in Example 9, except that another resin solution containing a polyurethane resin (thermoplastic resin) was used as the adhesiveness improver, a test substrate was produced. Adhesiveness of the conductive film 2 was tested by the cross-cut tape method. The number of squares, which remained without being peeled, was 5 among 25 squares.

### [Example 11]

In the same manner as in Example 9, except that another resin solution containing a polyurethane resin (thermoplastic resin) was used as the adhesiveness improver, a test substrate was produced. Adhesiveness of the conductive film 2 was tested by the cross-cut tape method. The number of squares, which remained without being peeled, was 5 among 25 squares.

### [Example 12]

In the same manner as in Example 11, except that the same non-alkali glass as in Example 7 was used as the base material 31, a vinyl chloride resin-based adhesive containing a polyvinyl chloride resin (thermoplastic resin) was used as the adhesiveness improver, a test substrate was produced. Adhesiveness of the conductive film 2 was tested by the cross-cut tape method. The number of squares, which remained without being peeled, was 5 among 25 squares.

### [Example 13]

In the same manner as in Example 12, except that a styrol resin-based adhesive containing a styrol resin (thermoplastic resin) was used as the adhesiveness improver, a test substrate was produced. Adhesiveness of the conductive film 2 was tested by the cross-cut tape method. The number of squares, which remained without being peeled, was 5 among 25 squares.

### [Example 14]

Initial make-up of electrolytic bath of an electroless copper plating solution was performed. The composition of this plating solution was as follows: 2.0 g/L of copper sulfate pentahydrate as a supply source of divalent copper ions, 5.0 g/L of formaldehyde as a reducing agent, 30.0 g/L of ethylenediaminetetraacetic acid (EDTA) as a chelating agent, 9.6 g/L of sodium hydroxide as a pH adjustor, and pure water (balance). The pH (20°C) of the plating solution was adjusted to 12.8.

In the same manner as in Example 4, a test substrate before applying plating was produced. The sample substrate was washed with pure water and then immersed in the above electroless copper plating solution, and electroless copper plating was applied to the sample substrate under the condition of a liquid temperature of 50°C. The sample substrate was washed with pure water and dried. The plating thickness of the conductive film 2 was 5 µm. Adhesiveness of this conductive film 2 was tested by the cross-cut tape method. The number of squares, which remained without being peeled, was 25 among 25 squares.

### [Example 15]

In the same manner as in Example 14, except that the same resin solution as in Example 5 was used as the adhesiveness improver, a test substrate was produced. Adhesiveness of the conductive film 2 was tested by the cross-cut tape method. The number of squares, which remained without being peeled, was 25 among 25 squares.

### [Example 16]

In the same manner as in Example 15, except that the same non-alkali glass as in Example 8 was used as the base material 31, the same resin solution as in Example 8 was used as the adhesiveness improver, and the plating thickness of the conductive film 2 was set to 1 µm, a test substrate was produced. Adhesiveness of the conductive film 2 was tested by the cross-cut tape method. The number of squares, which remained without being peeled, was 3 among 25 squares.

Examples 1 to 13 mentioned above revealed that the use of the adhesiveness improver containing a thermoplastic resin enables application of electroplating on a photo-sintered film, and an increase in thickness of the conductive film 2. Examples 14 to 16 revealed that the use of the adhesiveness improver containing a thermoplastic resin enables application of electroless plating on a photo-sintered film, and an increase in thickness of the conductive film 2.

### (Comparative Example 1)

In the same manner as in Example 1, except that a resin solution containing an epoxy mixture (thermosetting resin) as a main component was used as a primer containing no thermoplastic resin instead of the adhesiveness improver, the film of the primer after drying was set to 1 µm, and the plating thickness of the conductive film 2 was set to 5 µm, a test substrate was produced. The conductive film 2 was peeled during plating.

### (Comparative Example 2)

In the same manner as in Comparative Example 1, except that another resin solution containing an epoxy resin mixture (thermosetting resin) as a main component was used as the primer, a test substrate was produced. The conductive film 2 was peeled during plating.

### (Comparative Example 3)

In the same manner as in Comparative Example 2, except that an inorganic solution containing titanium oxide as a main component was used as the primer, a test substrate was produced. The conductive film 2 was peeled during plating.

### (Comparative Example 4)

In the same manner as in Comparative Example 1, except that the same non-alkali glass as in Example 7 was used as the base material 31, a test substrate was produced. The conductive film 2 was peeled during plating.

### (Comparative Example 5)

In the same manner as in Comparative Example 4, except that the same resin solution as in Comparative Example 2 was used as the primer, a test substrate was produced. The conductive film 2 was peeled during plating.

### (Comparative Example 6)

In the same manner as in Comparative Example 5, except that the same inorganic solution as in Comparative Example 3 was used as the primer, a test substrate was produced. The conductive film 2 was peeled during plating.

### (Comparative Example 7)

In the same manner as in Comparative Example 6, except that a silane coupling agent having an amino group was used as the primer and the thickness of the primer was set to 0.1 µm, a test substrate was produced. The conductive film 2 was peeled during plating.

### (Comparative Example 8)

In the same manner as in Comparative Example 7, except that another silane coupling agent having another epoxy group was used as the primer, a test substrate was produced. The conductive film 2 was peeled during plating.

### (Comparative Example 9)

In the same manner as in Comparative Example 6, except that a soda glass was used as the base material 31 and a resin solution containing a bisphenol A type epoxy resin (thermosetting resin) as a main component was used as the primer, a test substrate was produced. The conductive film 2 was peeled during plating.

### (Comparative Example 10)

In the same manner as in Comparative Example 9, except that another resin solution of a two-liquid reaction type containing a bisphenol A type epoxy resin (thermosetting resin) and an alkoxysilane as main components was used as the primer, a test substrate was produced. The conductive film 2 was peeled during plating.

### (Comparative Example 11)

In the same manner as in Comparative Example 10, except that another resin solution containing an epoxy resin (thermosetting resin) and an alkoxysilane as main components was used as the primer, a test substrate was produced. The conductive film 2 was peeled during plating.

### (Comparative Example 12)

In the same manner as in Comparative Example 11, except that another resin solution of a two-liquid reaction type containing a thermosetting resin as a main component was used as the primer, a test substrate was produced. The conductive film 2 was peeled during plating.

Comparative Examples 1 to 12 mentioned above revealed that the use of the primer containing no thermoplastic resin instead of the adhesiveness improver cannot achieve sufficient adhesiveness of the conductive film 2 to the primer and makes it impossible to apply plating to the primer.

The present invention is not limited to configurations of the above-mentioned embodiments, and various modifications can be made without departing from the spirit or scope of the present invention. For example, the shape of the base material 31 is not limited to a plate shape and may be any three-dimensional shape.

### EXPLANATION OF SYMBOLS

- 1 :: Circuit board
- 2 :: Conductive film
- 21 :: Copper particulates
- 3 :: Substrate
- 31 :: Base material
- 4 :: Resin layer
- 5 :: Plating

## Claims

1. A circuit board comprising a circuit including a conductive film, and a substrate, which further comprises:
a resin layer between the substrate and the conductive film, wherein
the substrate is made of a non-thermoplastic base material,
the resin layer contains a thermoplastic resin, and
the conductive film is formed by photo sintering of a film composed of copper particulates.

2. The circuit board according to claim 1, wherein the thermoplastic resin is selected from the group consisting of a thermoplastic polyimide resin, a polyamideimide resin, a polyphenylene sulfide resin, a polyurethane resin, a polyvinyl chloride resin and a styrol resin.

3. The circuit board according to claim 1 or 2, wherein plating is applied to the conductive film.

4. The circuit board according to claim 3, wherein the plating is electroplating or electroless plating.

5. An adhesiveness improver used in the formation of the resin layer in the circuit board according to any one of claims 1 to 4, which is produced by dissolving the thermoplastic resin in a solvent.

6. A conductive film forming method in which a conductive film is formed on a base material, which comprises the steps of:
forming a resin layer on a non-thermoplastic base material using an adhesiveness improver containing a thermoplastic resin,
forming a film composed of copper particulates on the resin layer using a copper particulate dispersion, and
subjecting the film to photo sintering.

7. The conductive film forming method according to claim 6, wherein the thermoplastic resin is selected from the group consisting of a thermoplastic polyimide resin, a polyamideimide resin, a polyphenylene sulfide resin, a polyurethane resin, a polyvinyl chloride resin and a styrol resin.

8. The conductive film forming method according to claim 6 or 7, which includes the step of applying plating to the photo-sintered film.

9. The conductive film forming method according to claim 8, wherein the plating is electroplating or electroless plating.

10. An adhesiveness improver used in the conductive film forming method according to any one of claims 6 to 9, which is produced by dissolving the thermoplastic resin in a solvent.
